# EUROPÄISCHE PATENTSCHRIFT

(11) **EP 2 428 293 B1**
(45) Veröffentlichungstag und Bekanntmachung des Hinweises auf die Patenterteilung: **01.11.2017**
(21) Anmeldenummer: 11006863.2
(22) Anmeldetag: 23.08.2011
(51) Int. Cl.: B22F 7/08, B22F 1/00, B22F 7/06, C09D 4/00, H01L 23/00

(54) **Kontaktierungsmittel und Verfahren zur Kontaktierung elektrischer Bauteile**
contacting medium and process for contacting electrical parts
agent de contact et procédé pour contacter des composants électriques

(30) Priorität: 03.09.2010 DE 102010044329
(43) Veröffentlichungstag der Anmeldung: 14.03.2012
(73) Patentinhaber: Heraeus Deutschland GmbH & Co. KG, 63450 Hanau (DE)
(72) Erfinder: Schäfer, Michael, 36093 Künzell (DE); Schmitt, Wolfgang, 63110 Rodgau (DE)
(74) Vertreter: Heraeus IP

(56) Entgegenhaltungen:
- WO-A1-2004/026526
- WO-A1-2009/133897
- DE-A1-102007 046 901
- DE-B3-102004 019 567
- JP-B2- 4 247 801
- US-A1- 2007 178 232

## Beschreibung

Die vorliegende Erfindung betrifft Sintervorformen und ein Verfahren zum Verbinden wenigstens zweier Bauelemente, bei dem diese Sintervorformen zum Einsatz kommen.

Im Bereich der Leistungselektronik stellt das Verbinden wenigstens zweier Bauelemente, beispielsweise von Substraten mit elektronischen Bauelementen, wie LEDs oder sehr dünnen Siliziumchips, die eine hohe Druck- und Temperaturempfindlichkeit aufweisen, eine besondere Herausforderung dar.

Aus diesem Grund werden Substrate mit solchen druck- und temperaturempfindlichen Bauelementen häufig durch Kleben verbunden. Geeignete Leitkleber enthalten üblicherweise Silberpartikel, duroplastische Polymere und Reaktivverdünner. Die Klebetechnik besitzt jedoch den Nachteil, dass damit Kontaktstellen zwischen Substrat und Bauelement geschaffen werden, die nur eine unzureichende Wärmeleitfähigkeit bzw. elektrische Leitfähigkeit aufweisen.

Um dieses Problem zu lösen, wurde vorgeschlagen, Bauelemente mit Substraten durch Sintern zu verbinden.

Bei diesen Sinterverfahren kommen üblicherweise Pasten zum Einsatz, die aus dem zu sinternden Metallpulver und einem Lösungsmittel bestehen.

Die DE 34 14 065 C2 schlägt hierzu vor, (i) eine solche Paste auf die zu verbindende Oberfläche eines elektronischen Bauelements oder Substrats aufzutragen, (ii) das Bauelement auf das Substrat aufzubringen, wobei die Paste zwischen dem Bauelement und dem Substrat angeordnet ist, (iii) das Lösungsmittel aus dem so hergestellten Verbund auszutreiben und (iv) den Verbund zu sintern.

Mit diesem Sinterverfahren gelingt das sichere Verbinden des elektronischen Bauelements mit dem Substrat. Als nachteilig hat sich jedoch erwiesen, dass das Lösungsmittel erst ausgetrieben wird, nachdem bereits der Verbund aus elektronischem Bauelement und Substrat hergestellt worden ist. Da in diesem Verbund die das Lösungsmittel enthaltende Paste bereits in Kontakt mit den zu verbindenden Oberflächen von elektronischem Bauelement und Substrat steht, ist ein einfaches und schnelles Ausgasen nicht mehr möglich, so dass der Verbund eine längere Zeit getrocknet werden muss.

Um dieses Problem zu lösen, wird gemäß der EP 0 242 626 B1 die Paste auf die zu verbindende Oberfläche des elektronischen Bauelements oder des Substrats aufgebracht und unmittelbar danach getrocknet. Erst nach dem Trocknen wird das Bauelement auf das Substrat aufgebracht, wobei die getrocknete Paste zwischen dem elektronischen Bauelement und dem Substrat angeordnet ist. Danach wird der so hergestellte Verbund gesintert.

Eine Weiterentwicklung dieses Verfahren ist aus der DE 10 2004 019 567 B3 bekannt. Dort wird vorgeschlagen, eine Paste als Schicht auf eine Trägerfolie aufzubringen und zu trocknen. Danach werden ein oder mehrere Bauelemente auf die Schicht aus getrockneter Paste gesetzt. Der Verbund aus Bauelement, Schicht aus getrockneter Paste und Trägerfolie wird anschließend mit Druck beaufschlagt, um die Haftkraft zwischen der getrockneten Paste und dem Bauelement zu erhöhen, so dass die getrocknete Paste an dem Bauelement anhaftet und damit von der Trägerfolie abgehoben werden kann. Im Folgenden kann das Bauelement mit der getrockneten Paste auf dem Substrat positioniert und der Verbund aus Substrat, Bauelement und dazwischen liegender Schicht aus getrockneter Paste gesintert werden.

Dieses Verfahren hat sich aus ökonomischer Sicht als vorteilhaft erwiesen, da es eine rationelle und zumindest teilweise parallele Verarbeitung einer Mehrzahl von Bauelementen sowie eine strukturierte Ausgestaltung der Sinterschicht ermöglicht.

Nachteilig ist dabei jedoch, dass dieses Sinterverfahren wie auch andere herkömmliche Sinterverfahren entweder einen hohen Prozessdruck (beispielsweise mehr als 30 MPa) oder aber eine hohe Prozesstemperatur (mehr als 250°C) erfordern. Diese Bedingungen führen häufig zu Schädigungen der zu verbindenden Bauelemente, so dass herkömmliche Sinterverfahren für viele Anwendungen ausscheiden.

In der DE 10 2007 046 901 A1 wird eine Sintertechnik vorgeschlagen, mit der es gelingt, sehr gut elektrisch leitende und wärmeleitende Verbindungsschichten für die Leistungselektronik aufzubauen. Bei diesem Sinterverfahren wird eine Metallpaste verwendet, die neben einem alkoholischen Lösungsmittel eine Silberverbindung enthält, die sich unter 300°C zu elementarem Silber zersetzt. Diese Metallpasten ermöglichen eine Verringerung des Prozessdrucks auf unter 3 bar und eine Verringerung der Prozesstemperatur auf unter 250°C. Diese Sintertechnik stellt einen großen Qualitätssprung bei der Verbindung von Substraten mit druck- und temperaturempfindlichen Bauelementen dar. Weitere Sinterpasten, die eine niedrige Sintertemperatur ermöglichen, sind aus JP4247801B und WO2009133897 bekannt. Allerdings wäre es für viele Anwendungen wünschenswert, wenn die Prozesstemperatur noch weiter gesenkt werden könnte. Dies würde zu einer geringeren Belastung der zu verbindenden Bauelemente und damit zu einer weiteren Qualitätssteigerung von Bauteilen auf dem Gebiet der Leistungselektronik sorgen. Darüber hinaus könnten bei einer weiteren Senkung der Prozesstemperatur in erheblichem Maße Energiekosten eingespart werden.

Der Erfindung liegt daher die Aufgabe zugrunde, ein Verfahren zum Verbinden wenigstens zweier Bauelemente zur Verfügung zu stellen, das eine prozessökonomisch vorteilhafte und zumindest teilweise parallele Verarbeitung einer Mehrzahl von Bauelementen, eine strukturierte Ausgestaltung der Sinterschicht sowie eine Erniedrigung der Sintertemperatur auf unter 250°C ermöglicht.

Diese Aufgabe wird gelöst durch ein Verfahren zum Verbinden wenigstens zweier Bauelemente, bei dem man
(i) eine Sintervorform bereitstellt, umfassend einen Träger mit einer Oberfläche, die wenigstens ein Strukturelement aufweist, das verfestigte Paste enthält, wobei die verfestigte Paste (a) Metallpartikel, die ein Coating aufweisen, das wenigstens eine organische Verbindung ausgewählt aus der Gruppe bestehend aus Fettsäuren, Fettsäuresalzen und Fettsäureestern enthält, und (b) wenigstens ein Sinterhilfsmittel, das aus der Gruppe ausgewählt ist, die aus (b1) Oxidationsmittel darstellenden anorganischen Säuren, (b2) Salzen ausgewählt aus der Gruppe bestehend aus Magnesiumformiat, Aluminiumformiat, Eisen(II)-formiat, Zinn(II)-formiat, Kupfer(II)-formiat, Silber(II)-formiat und Mangan(III)-formiat, (b3) Estern ausgewählt aus der Gruppe bestehend aus Methylformiat, Ethylformiat, Propylformiat und Butylformiat, und (b4) Carbonylkomplexen besteht, enthält, und die Oberfläche des Trägers, die die verfestigte Paste aufweist, gegenüber den Bestandteilen der Paste nicht reaktiv ist,
(ii) wenigstens ein erstes Bauelement mit einer zu verbindenden Oberfläche und ein zweites Bauelement mit einer zu verbindenden Oberfläche bereitstellt,
(iii) wenigstens ein Strukturelement auf der Oberfläche des Trägers der Sintervorform mit der zu verbindenden Oberfläche des ersten Bauelements kontaktiert, um eine Anordnung aus dem ersten Bauelement und dem wenigstens einen Strukturelement zu schaffen, die mit dem Träger in Kontakt steht,
(iv) die Anordnung aus dem ersten Bauelement und dem wenigstens einen Strukturelement von dem Träger entfernt,
(v) die zu verbindende Oberfläche des zweiten Bauelements mit dem wenigstens einen Strukturelement der Anordnung aus dem ersten Bauelement und dem wenigstens einen Strukturelement kontaktiert, um eine Sinteranordnung aus erstem Bauelement, zweiten Bauelement und dazwischen angeordnetem Strukturelement zu schaffen, und
(vi) die Sinteranordnung sintert.

Bei diesem Verfahren kommt eine Sintervorform zum Einsatz, umfassend einen Träger mit einer Oberfläche, die wenigstens ein Strukturelement aufweist, das verfestigte Paste enthält, wobei die verfestigte Paste
(a) Metallpartikel, die ein Coating aufweisen, das wenigstens eine organische Verbindung ausgewählt aus der Gruppe bestehend aus Fettsäuren, Fettsäuresalzen und Fettsäureestern enthält, und
   (b) wenigstens ein Sinterhilfsmittel, ausgewählt aus den oben genannten Gruppen, enthält,
wobei die verfestigte Paste 75 - 95 Gewichtsprozent Metallpartikel, 0,1 - 15 Gewichtsprozent Sinterhilfsmittel, 0 - 0,5 Gewichtsprozent Lösungsmittel, 0 - 12 Gewichtsprozent Metallprecursor und 0 - 10 Gewichtsprozent weitere Bestandteile enthält, bezogen auf das Gewicht der verfestigten Paste, und
die Oberfläche des Trägers, die die verfestigte Paste aufweist, gegenüber den Bestandteilen der Paste nicht reaktiv ist.

Beim erfindungsgemäßen Verfahren werden wenigstens zwei Bauelemente miteinander verbunden.

Vorzugsweise werden mehrere Bauelemente nebeneinander, beispielsweise in einer Ebene, auf einem anderen Bauelement befestigt.

Der Begriff Bauelement ist nicht weiter eingeschränkt. Im weitesten Sinne sind darunter Objekte zu verstehen, die miteinander verbunden werden können.

Gemäß einer bevorzugten Ausführungsform handelt es sich bei einem der zu verbindenden Bauelemente um ein elektronisches Bauelement und bei dem anderen zu verbindenden Bauelement um ein Substrat.

Gemäß einer besonders bevorzugten Ausführungsform werden mit dem erfindungsgemäßen Verfahren unter Verwendung der erfindungsgemäßen Sintervorform mehrere elektronische Bauelemente nebeneinander, beispielsweise in einer Ebene, auf einem Substrat befestigt.

Unter elektronischem Bauelement wird in allgemeiner Art ein Gegenstand verstanden, der Teil einer elektronischen Anordnung sein kann. Gemäß einer bevorzugten Ausführungsform wird darunter ein nicht weiter zerlegbares Einzelteil verstanden, das als Bestandteil einer elektronischen Schaltung dienen kann. Das elektronische Bauelement kann als Einheit gegebenenfalls aus mehreren Bauteilen bestehen. Bei dem elektronischen Bauelement kann es sich beispielsweise um ein aktives Bauelement oder ein passives Bauelement handeln. Gemäß besonderen Ausführungsformen werden die elektronischen Bauelemente in der Hochleistungselektronik verwendet. Gemäß einer bevorzugten Ausführungsform ist das elektronische Bauelement aus der Gruppe ausgewählt, die aus Dioden (zum Beispiel LEDs, *Light Emitting Diodes,* lichtemittierende Dioden), Transistoren (zum Beispiel IGBTs, *Insulated-Gate Bipolar Transistors*, Bipolartransistoren mit isolierter Gate-Elektrode), integrierten Schaltungen, Halbleiterchips, Nacktchips (*Dies*), Widerständen, Sensoren, Kondensatoren, Spulen und Kühlkörpern besteht.

Unter Substrat wird in allgemeiner Form ein Gegenstand verstanden, der mit einem elektronischen Bauelement verbindbar ist. Gemäß einer bevorzugten Ausführungsform ist das Substrat aus der Gruppe ausgewählt, die aus Leadframes, DCB-Substraten (*Direct-Copper-Bonded-*Substraten)und keramischen Substraten besteht.

Gemäß einer bevorzugten Ausführungsform werden folgende Paare aus elektronischem Bauelement und Substrat miteinander verbunden: LED/Leadframe, LED/keramisches Substrat, Die/Leadframe, Die/keramisches Substrat, Die/DCB-Substrat, Diode/Leadframe, Diode/keramisches Substrat, Diode/DCB-Substrat, IGBT/Leadframe, IGBT/keramisches Substrat, IGBT/DCB-Substrat, integrierte Schaltung/Leadframe, integrierte Schaltung/keramisches Substrat, integrierte Schaltung/DCB-Substrat, Sensor/Leadframe, Sensor/keramisches Substrat, Kühlkörper (vorzugsweise Kupfer- oder Aluminiumkühlkörper)/DCB, Kühlkörper (vorzugsweise Kupfer- oder Aluminiumkühlkörper)/keramisches Substrat, Kühlkörper/Leadframe, Kondensator (vorzugsweise Tantalkondensator, mehr bevorzugt in ungehäustem Zustand)/Leadframe.

Die zu verbindenden Bauelemente können jeweils wenigstens eine Metallisierungsschicht umfassen. Diese Metaflisierungsschicht kann beispielsweise reines Metall oder eine Metalllegierung aufweisen. Weist die Metallisierungsschicht ein Metall auf, so ist dieses vorzugsweise aus der Gruppe ausgewählt, die aus Kupfer, Silber, Gold, Palladium und Platin besteht. Weist die Metallisierungsschicht eine Metalllegierung auf, so enthält diese vorzugsweise wenigstens ein Metall, das aus der Gruppe ausgewählt ist, die aus Silber, Gold, Nickel, Palladium und Platin besteht. Die Metallisierungsschicht kann auch einen mehrlagigen Aufbau aufweisen. Gemäß einer weiteren bevorzugten Ausführungsform enthält die Metallisierungsschicht auch ein Glas.

Erfindungsgemäß wird unter dem Verbinden von wenigstens zwei Bauelementen das Befestigen von einem ersten Bauelement auf einem zweiten Bauelement verstanden. In diesem Zusammenhang bedeutet "auf" lediglich, dass eine Oberfläche des ersten Bauelements mit einer Oberfläche des zweiten Bauelements verbunden ist, wobei es auf die relative Lage der beiden Bauelemente oder der Anordnung, die die wenigstens zwei Bauelemente enthält, nicht ankommt.

Für das erfindungsgemäße Verfahren wird zunächst eine erfindungsgemäße Sintervorform bereitgestellt.

Unter Sintervorform ist im weitesten Sinne eine Anordnung zu verstehen, mit deren Hilfe auf einfache Weise auf den Oberflächen zweier Bauelemente eine Paste appliziert werden kann, die beim erfindungsgemäßen Sinterverfahren zum Einsatz kommt.

Diese Sintervorform umfasst einen Träger mit einer Oberfläche, die wenigstens ein Strukturelement aufweist, das verfestigte Paste enthält.

Der Träger weist eine Oberfläche aus einem Material auf, das gegenüber den Bestandteilen der Paste bzw. der Paste selbst nicht reaktiv, insbesondere chemisch inert, ist.

Im Rahmen der Erfindung ist das Material der Trägeroberfläche nicht reaktiv, wenn es nicht sinterfähig ist. Das Material der Trägeroberfläche ist nicht sinterfähig, wenn es dergestalt ist, dass keine Diffusionsprozesse zwischen dem Material der Trägeroberfläche und den in der Paste enthaltenen Metallpartikeln ablaufen. Dementsprechend ist es bevorzugt, dass bei einer Temperatur von 25°C und einem Druck von 1013 hPa keine Wechselwirkungen zwischen dem Material der Trägeroberfläche und den Pastenbestandteilen stattfinden, die den Träger für die Aufnahme der Paste und die Paste für einen Sintervorgang unbrauchbar machen. Ferner sollte die Trägeroberfläche aus einem Material sein, das ein einfaches Ablösen der verfestigten Paste vom Träger gestattet.

Gemäß einer bevorzugten Ausführungsform ist das Material der Trägeroberfläche dergestalt, das keine Diffusionswechselwirkungen zwischen dem Material der Trägeroberfläche und den in der Paste enthaltenen Metallpartikeln, wohl aber Adhäsionswechselwirkungen zwischen dem Material der Trägeroberfläche und der verfestigten Paste vorherrschen.

Dadurch, dass das Material der Trägeroberfläche gegenüber den Bestandteilen der Paste bzw. der Paste selbst nicht reaktiv ist, ist gewährleistet, dass bei der Durchführung des erfindungsgemäßen Verfahrens eine Anordnung aus einem ersten Bauelement und dem wenigstens einen Strukturelement leicht von dem Träger ablösbar ist.

Gemäß einer bevorzugten Ausführungsform ist der Träger aus der Gruppe ausgewählt, die aus nichtmetallischen Materialien, metallischen Keramiken und metallischen Materialien, die auf ihrer Oberfläche eine Oxidschicht aufweisen, besteht.

Als nichtmetallische Materialien kommen insbesondere Polymere, Gläser und nicht-metallische Keramiken in Betracht. Gemäß einer besonders bevorzugten Ausführungsform ist der Träger aus Polyester, Polyimid oder Polyethersulfon gefertigt.

Unter metallischen Keramiken sind Keramiken zu verstehen, die wenigstens ein Metall enthalten. Beispielsweise kann als metallische Keramik für den Träger eine Aluminiumöxidkeramik verwendet werden.

Metallische Materialien, die auf ihrer Oberfläche eine Oxidschicht aufweisen, sind vorzugsweise Metalle, die in Gegenwart von Luftsauerstoff passivieren. Dazu zählen insbesondere Aluminium, Nickel und Eisen.

Erfindungsgemäß besitzt der Träger eine Oberfläche, die wenigstens ein Strukturelement aufweist, das verfestigte Paste enthält.

Das wenigstens eine Strukturelement befindet sich erfindungsgemäß auf der Oberfläche des Trägers.

Gemäß einer bevorzugten Ausführungsform besitzt der Träger eine Oberfläche, die mehrere Strukturelemente aufweist, die verfestigte Paste enthalten. Mehrere Strukturelemente legen definitionsgemäß eine Struktur fest. Diese Strukturelemente können die gleiche oder eine unterschiedliche Geometrie aufweisen. Ferner können die einzelnen Strukturelemente gleichmäßig oder ungleichmäßig angeordnet sein. Vorzugsweise befinden sich die Strukturelemente auf dem Träger beabstandet nebeneinander, also in einer Ebene.

Die Anzahl und die Geometrie der Strukturelemente sowie die Anordnung der Strukturelemente auf dem Träger sind nicht weiter eingeschränkt. Vorzugsweise werden Anzahl und Geometrie der Strukturelemente sowie die Anordnung der Strukturelemente auf dem Träger jedoch so gewählt, dass das durch die Strukturelemente erzeugte Muster dem Muster entspricht, mit dem einzelne, nebeneinander, beispielsweise in einer Ebene, befindliche Bauelemente auf einem anderen Bauelement befestigt werden sollen.

Beispielsweise können mehrere elektronische Bauelemente, zum Beispiel Halbleiterchips, mit einem Substrat, zum Beispiel einem Leadframe, verbunden werden. Üblicherweise weist ein solcher Leadframe Kontaktstellen auf, die für die Verbindung mit dem Halbleiterchip vorgesehen sind. In einem solchen Fall kann die Sintervorform so ausgestaltet sein, dass Strukturelemente, die verfestigte Paste enthalten, auf der Oberfläche des Trägers in einem Muster angeordnet sind, das dem Muster der Kontaktstellen auf dem Leadframe entspricht. Diese Anordnung der Strukturelemente auf dem Träger gewährleistet, dass die später mit den Halbleiterchips bestückten Strukturelemente auf die Kontaktstellen des Leadframes übertragen werden können und sich die Halbleiterchips auf den dafür vorgesehenen Kontaktstellen auf dem Leadframe befinden.

Die Strukturelemente auf der Oberfläche des Trägers enthalten eine verfestigte Paste.

Diese Paste ist so ausgestaltet, dass sie ein stabiles Verbinden der Bauelemente bereits bei Temperaturen von unter 250°C ermöglicht.

Die erfindungsgemäß verwendete Paste enthält Metallpartikel (a).

Der Begriff Metallpartikel ist im Rahmen der Erfindung nicht auf Partikel aus reinen Metallen beschränkt. Vom Begriff Metallpartikel umfasst sind vielmehr alle Partikel, die einen Metallanteil aufweisen. Dieser Metallanteil beträgt vorzugsweise wenigstens 50 Gewichtsprozent, noch mehr bevorzugt wenigstens 70 Gewichtsprozent, besonders bevorzugt wenigstens 90 Gewichtsprozent und ganz besonders bevorzugt wenigstens 95 Gewichtsprozent, bezogen auf das Gewicht der Metallpartikel. Insbesondere fallen unter den Begriff Metallpartikel auch Partikel aus einer Metalllegierung oder einer intermetallischen Phase. Ferner sind vom Begriff Metallpartikel auch Partikel umfasst, die wenigstens zwei Lagen enthalten, die unterschiedliche Metalle, Metalllegierungen oder intermetallische Phasen aufweisen können. Bei diesen Metallpartikeln kann es sich zudem um gleichartige oder verschiedene Metallpartikel handeln. Insbesondere können in der Paste Mischungen verschiedener Metallpartikel enthalten sein.

Im Rahmen der Erfindung bezieht sich der Begriff Metall auf ein Element, das im Periodensystem der Elemente in der selben Periode wie Bor, aber links von Bor, in der selben Periode wie Silicium, aber links von Silicium, in der selben Periode wie Germanium, aber links von Germanium, und in der selben Periode wie Antimon, aber links von Antimon steht, sowie auf alle Elemente, die eine höhere Ordnungszahl als 55 aufweisen.

Gemäß einer besonders bevorzugten Ausführungsform enthält die Paste Metallpartikel, die ein Metall in einer Reinheit von wenigstens 95 Gewichtsprozent, mehr bevorzugt von wenigstens 98 Gewichtsprozent, noch mehr bevorzugt von wenigstens 99 Gewichtsprozent und ganz besonders bevorzugt von wenigstens 99,9 Gewichtsprozent aufweisen.

Gemäß einer weiteren bevorzugten Ausführungsform ist das Metall aus der Gruppe ausgewählt, die aus Kupfer, Silber, Nickel und Aluminium besteht. Gemäß einer besonders bevorzugten Ausführungsform ist das Metall Silber oder Kupfer. Gemäß einer ganz besonders bevorzugten Ausführungsform ist das Metall Silber.

Sind in der erfindungsgemäß verwendeten Paste Metallpartikel enthalten, die eine Metalllegierung aufweisen, so umfasst diese vorzugsweise wenigstens ein Metall, das aus der Gruppe ausgewählt ist, die aus Aluminium, Nickel, Kupfer, Silber, Gold, Palladium und Platin besteht. Die Metalllegierung umfasst gemäß einer besonders bevorzugten Ausführungsform wenigstens zwei Metalle, die aus der Gruppe ausgewählt sind, die aus Aluminium, Nickel, Kupfer, Silber, Gold, Palladium und Platin besteht. Es kann ferner bevorzugt sein, dass der Anteil der Metalle, die aus der Gruppe ausgewählt sind, die aus Aluminium, Nickel, Kupfer, Silber, Gold, Palladium und Platin besteht, an der Metalllegierung wenigstens 90 Gewichtsprozent, mehr bevorzugt wenigstens 95 Gewichtsprozent, besonders bevorzugt wenigstens 99 Gewichtsprozent und ganz besonders bevorzugt 100 Gewichtsprozent beträgt. Bei der Legierung kann es sich beispielsweise um eine Legierung handeln, die Kupfer und Silber, Kupfer, Silber und Gold, Kupfer und Gold, Silber und Gold, Silber und Palladium, Platin und Palladium oder Nickel und Palladium enthält.

Sind in der erfindungsgemäß verwendeten Paste Metallpartikel enthalten, die wenigstens zwei Lagen umfassen, die unterschiedliche Metalle, Metalllegierungen oder intermetallische Phasen aufweisen, so handelt es sich dabei vorzugsweise um Partikel aus einem Metall, einer Metalllegierung oder einer intermetallischen Phase enthaltend wenigstens ein Metall, das aus der Gruppe ausgewählt ist, die aus Aluminium, Nickel, Kupfer, Silber, Gold, Palladium und Platin besteht, wobei diese Partikel mit einer davon verschiedenen Beschichtung aus einem Metall, einer Metalllegierung oder einer intermetallischen Phase umgeben sind, enthaltend wenigstens ein Metall, das aus der Gruppe ausgewählt ist, die aus Aluminium, Nickel, Kupfer, Silber, Gold, Palladium und Platin besteht. Ganz besonders bevorzugt sind Kupferpartikel, die mit Silber beschichtet sind.

Die Metallpartikel können von unterschiedlicher Gestalt sein. Beispielsweise können die Metallpartikel in der Form von Flakes oder einer sphärischen (kugeligen) Form vorliegen. Gemäß einer besonders bevorzugten Ausführungsform weisen die Metallpartikel die Form von Flakes auf. Dies schließt jedoch nicht aus, dass von den eingesetzten Metallpartikeln auch ein untergeordneter Anteil eine andere Form aufweisen kann. Es ist jedoch bevorzugt, dass wenigstens 70 Gewichtsprozent, mehr bevorzugt wenigstens 80 Gewichtsprozent, noch mehr bevorzugt wenigstens 90 Gewichtsprozent oder 100 Gewichtsprozent der Partikel in der Form von Flakes vorliegen.

Liegen die Metallpartikel in sphärischer Form vor, so weisen die Metallpartikel vorzugsweise einen mittleren Teilchendurchmesser von 0,1 - 20 µm, mehr bevorzugt von 1 - 15 µm und noch mehr bevorzugt von 2 - 10 µm auf. Unter mittlerem Teilchendurchmesser wird erfindungsgemäß verstanden, dass wenigstens 90 Prozent der Partikel einen Teilchendurchmesser im angegebenen Bereich aufweisen. Beispielsweise bedeutet ein mittlerer Teilchendurchmesser von 0,1 - 20 µm, dass wenigstens 90 Prozent der Partikel einen Teilchendurchmesser im Bereich von 0,1 - 20 µm und weniger als 10 Prozent der Partikel einen Teilchendurchmesser von weniger als 0,1 µm oder mehr als 20 µm aufweisen.

Erfindungsgemäß sind die Metallpartikel gecoatet.

Unter einem Coating von Partikeln wird erfindungsgemäß eine festhaftende Schicht auf der Oberfläche von Partikeln verstanden. Erfindungsgemäß bedeutet festhaftende Schicht, dass sich die Schicht nicht bereits gravitationsbedingt von den Metallpartikeln löst.

Erfindungsgemäß enthält das Coating der Metallpartikel wenigstens eine Coatingverbindung. Diese wenigstens eine Coatingverbindung ist eine organische Verbindung.

Bei dieser wenigstens einen Coatingverbindung handelt es sich um eine Verbindung, die aus der Gruppe ausgewählt ist, die aus Fettsäuren, Fettsäuresalzen und Fettsäureestern besteht. Diese Coatingverbindungen sollen eine Agglomeration der in der Paste enthaltenen Metallpartikel vermeiden und zur Stabilisierung der Paste beitragen.

Die erfindungsgemäß eingesetzten Coatingverbindungen sind vorzugsweise aus der Gruppe ausgewählt, die aus gesättigten Verbindungen, einfach ungesättigten Verbindungen, mehrfach ungesättigten Verbindungen und Mischungen davon besteht.

Die Coatingverbindungen sind ferner vorzugsweise aus der Gruppe ausgewählt, die aus verzweigten Verbindungen, unverzweigten Verbindungen und Mischungen davon besteht.

Die Coatingverbindungen weisen vorzugsweise 8 - 28, noch mehr bevorzugt 12 - 24 und besonders bevorzugt 12 - 18 Kohlenstoffatome auf.

Gemäß einer bevorzugten Ausführungsform handelt es sich bei den Coatingverbindungen um Monofettsäuren, Salze von Monofettsäuren, Monofettsäureester und Mischungen davon.

Als Fettsäuresalze kommen vorzugsweise Salze in Betracht, deren anionische Komponente die deprotonierte Fettsäure darstellt, und deren kationische Komponente aus der Gruppe ausgewählt ist, die aus Ammoniumionen, Monoalkylammoniumionen, Dialkylammoniumionen, Trialkylammoniumionen, Lithiumionen, Natriumionen, Kaliumionen, Kupferionen und Aluminiumionen besteht.

Bevorzugte Fettsäureester leiten sich von den entsprechenden Fettsäuren ab, wobei die Hydroxylgruppen der Säureeinheiten durch Alkylgruppen, insbesondere Methylgruppen, Ethylgruppen, Propylgruppen oder Butylgruppen, ersetzt sind.

Gemäß einer bevorzugten Ausführungsform ist die wenigstens eine Coatingverbindung aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Stearinsäure (Octadecansäure), Mischungen davon, sowie den entsprechenden Estern und Salzen sowie Mischungen davon, besteht.

Gemäß einer besonders bevorzugten Ausführungsform ist die wenigstens eine Coatingverbindung aus der Gruppe ausgewählt, die aus Laurinsäure (Dodecansäure), Stearinsäure (Octadecansäure), Natriumstearat, Kaliumstearat, Aluminiumstearat, Kupferstearat, Natriumpalmitat und Kaliumpalmitat besteht.

Die erfindungsgemäß verwendeten Metallpartikel sind kommerziell erhältlich. Die erfindungsgemäß verwendeten Coatingverbindungen können mittels herkömmlicher und aus dem Stand der Technik bekannter Verfahren auf die Oberfläche der Metallpartikel aufgetragen werden.

Beispielsweise ist es möglich, die Coatingverbindungen, insbesondere die vorstehend erwähnten Stearate oder Palmitate, in Lösungsmitteln aufzuschlämmen und die aufgeschlämmten Coatingverbindungen in Kugelmühlen mit den Metallpartikeln zu vermahlen. Nach dem Mahlen werden die nun mit den Coatingverbindungen beschichteten Metallpartikel getrocknet und anschließend entstaubt.

Vorzugsweise beträgt der Anteil der wenigstens einen Coatingverbindung, die aus der Gruppe ausgewählt ist, die aus Fettsäuren, Fettsäuresalzen und Fettsäureestern besteht, bezogen auf das Gesamtgewicht des Coatings, wenigstens 80 Gewichtsprozent, mehr bevorzugt wenigstens 90 Gewichtsprozent, besonders bevorzugt wenigstens 95 Gewichtsprozent, ganz besonders bevorzugt wenigstens 99 Gewichtsprozent und insbesondere 100 Gewichtsprozent.

Gemäß einer bevorzugten Ausführungsform beträgt der Anteil der Coatingverbindungen 0,05 - 3 Gewichtsprozent, mehr bevorzugt 0,07 - 2,5 Gewichtsprozent und noch mehr bevorzugt 0,1 - 2,2 Gewichtsprozent, bezogen auf das Gewicht der gecoateten Metallpartikel.

Der Coatinggrad, der als Verhältnis der Masse an Coatingverbindungen zur Oberfläche der Metallpartikel definiert ist, beträgt vorzugsweise 0,00005 - 0,03 g, mehr bevorzugt 0,0001 - 0,02 g und noch mehr bevorzugt 0,0005 - 0,02 g an Coatingverbindungen pro Quadratmeter (m²) Oberfläche der Metallpartikel.

Die Paste enthält erfindungsgemäß wenigstens ein Sinterhilfsmittel. Dieses Sinterhilfsmittel ist vorzugsweise in der Lage, während des Sinterprozesses bei Temperaturen unter 250°C ein Abbrennen der Coatingverbindungen bei unter 250°C zu gewährleisten, um so ein Sintern bei Temperaturen von unter 250°C zu ermöglichen. Besonders geeignete Sinterhilfsmittel gewährleisten ein Abbrennen der Coatingverbindungen bei Temperaturen unter 250°C entweder direkt oder indirekt durch intermediär gebildete Verbindungen.

Das Sinterhilfsmittel ist erfindungsgemäß aus der Gruppe ausgewählt, die aus (b1) Oxidationsmittel darstellenden anorganischen Säuren, (b2) Salzen ausgewählt aus der Gruppe bestehend aus Magnesiumformiat, Aluminiumformiat, Eisen(II)-formiat, Zinn(II)-formiat, Kupfer(II)-formiat, Silber(II)-formiat und Mangan(III)-formiat, (b3) Estern ausgewählt aus der Gruppe bestehend aus Methylformiat, Ethylformiat, Propylformiat und Butylformiat, und (b4) Carbonylkomplexen besteht.

Die als Sinterhilfsmittel gemäß einer Ausführungsform verwendbaren anorganischen Säuren (b1) stellen Oxidationsmittel dar.

Unter Oxidationsmittel ist ein Stoff zu verstehen, der andere Stoffe oxidieren kann und dabei selbst reduziert wird. Ein Oxidationsmittel kann Elektronen aufnehmen und ist somit ein Elektronenakzeptor. Vorzugsweise ist das Sinterhilfsmittel gemäß dieser Ausführungsform auch ein Sauerstoffüberträger. Damit ist ein Stoff gemeint, der Sauerstoff abgeben kann. Diese Verbindungen können als Sinterhilfsmittel dienen, da sie wenigstens ein Sauerstoffatom enthalten und ein Verbrennen der Coatingverbindungen, die auf den Metallpartikeln der Paste vorhanden sind, bei einer Temperatur von unter 250°C ermöglichen.

Die Eignung von (b1) anorganischen Säuren, als Sinterhilfsmittel dienen zu können, geht auf die Erkenntnis zurück, dass es für das Sintern von Bauelementen unter Verwendung von Pasten vorteilhaft ist, wenn die in der Paste enthaltenen Partikel, vorzugsweise mit Fettsäuren, gecoatet sind. Sind die Metallpartikel nicht gecoatet, dann kommt es zu einer Agglomeration der Metallpartikel in der Metallpaste und zu einer Verklumpung der Metallpartikel in einem frühen Stadium während des Sinterprozesses. Dies hat oft inhomogene Kontaktstellen zwischen den zu verbindenden Bauelementen zur Folge.

Überraschenderweise wurde herausgefunden, dass derart gecoatete Metallpartikel allerdings auch ursächlich dafür sind, dass die Sintertemperatur nicht auf unter 250°C gesenkt werden kann. Solange sich die Coatingverbindungen auf der Oberfläche der Metallpartikel befinden, wird zwar einerseits eine Agglomeration der Metallpartikel verhindert. Andererseits stehen aber auch die Oberflächen der Metallpartikel nicht für den Sintervorgang zur Verfügung, so dass die Metallpartikel nicht gesintert werden können.

In herkömmlichen Sinterverfahren werden die Coatingverbindungen bei den üblicherweise für das Sintern verwendeten Temperaturen von weit über 250°C im Laufe des Sinterprozesses abgebrannt. Erst nach dem Abbrennen der Coatingverbindungen sind die Oberflächen der Metallpartikel für den Sinterprozess zugänglich. Daher sind Sinterprozesse mit den herkömmlich eingesetzten, gecoateten Metallpartikeln erst bei Temperaturen von weit oberhalb von 250°C möglich.

Überraschenderweise wurde gefunden, dass (b1) anorganische Säuren ein Abbrennen der Coatingverbindungen bei Temperaturen von unter 250°C gewährleisten. Bei diesen Sinterhilfsmitteln handelt es sich um sauerstoffhaltige Oxidationsmittel, die sicherstellen, dass die auf den Metallpartikeln enthaltenen Coatingverbindungen bei Temperaturen unterhalb von 250°C entfernt werden. Somit stehen bereits bei Temperaturen von unter 250°C die Oberflächen der Metallpartikel für den Sinterprozess zur Verfügung. Ebenfalls überraschend war, dass es trotz des Abbrennens der Coatingverbindungen bei Temperaturen von unter 250°C nicht zu einer Agglomeration der Metallpartikel kommt, sondern homogene und stabile Kontaktstellen zwischen den zu verbindenden Bauelementen entstehen.

Ferner wurde ebenfalls überraschenderweise gefunden, dass die unter der Coatingschicht liegende Oberfläche der Metallpartikel zumeist wenigstens zu einem Teil oxidiert ist. Solche Metalloxidschichten beeinträchtigen die für das Sintern erforderlichen Diffusionsprozesse und haben somit eine Verlangsamung der Diffusionsgeschwindigkeit zur Folge. Aus diesem Grund ist es beim Sintern mittels dieser an der Oberfläche oxidierten Metallpartikel herkömmlicherweise nötig, hohe Prozesstemperaturen von weit über 250°C zu verwenden.

Erfindungsgemäß entsteht beim Abrennen der Coatingverbindungen unter anderem Kohlenmonoxid. Das während dem Sintern freigesetzte Kohlenmonoxid ist ein Reduktionsmittel und als solches in der Lage, das auf der Oberfläche der Metallpartikel vorhandene Metalloxid zu reduzieren. Die Entfernung des Metalloxids gewährleistet eine behinderungsfreie Diffusion und damit einhergehend eine Steigerung der Diffusionsgeschwindigkeit. Bei dieser Reduktion des Metalloxids wird außerdem *in situ* reaktives Metall erzeugt, das den Sinterprozess weiter begünstigt. Ferner kann dieses reaktive Metall während des Sinterprozesses zwischen den Metallatomen der Metallpartikel vorhandene Lücken auffüllen und so die Porosität der Kontaktstelle zwischen den zu verbindenden Bauelementen signifikant erniedrigen. Dadurch werden äußerst stabile und wärmeleitfähige sowie elektrisch leitfähige Kontaktstellen erzeugt.

Vorzugsweise handelt es sich bei den anorganischen Säuren um sauerstoffhaltige anorganische Säuren.

Gemäß einer weiteren bevorzugten Ausführungsform werden als anorganische Säuren Phosphorsäuren eingesetzt. Unter Phosphorsäuren sind allgemein anorganische Säuren zu verstehen, die wenigstens ein Phosphoratom aufweisen.

Bevorzugte Phosphorsäuren, die erfindungsgemäß als Sinterhilfsmittel eingesetzt werden können, sind ortho-Phosphorsäure, Diphosphorsäure, Metaphosphorsäuren und Polyphosphorsäuren.

Gemäß einer weiteren bevorzugten Ausführungsform handelt es sich bei dem wenigstens einen Sinterhilfsmittel um (b2) ein der o.g. Salze (b3) einen der o.g. Ester oder, (b4) einen Carbonylkomplex. Diese Sinterhilfsmittel gewährleisten offenbar, dass den Sinterprozess störende Metalloxide, die auf der Oberfläche der in der Paste enthaltenen Metallpartikel vorhandenen sein können, reduziert werden. Aus diesem Grund können als Sinterhilfsmittel auch solche Verbindungen eingesetzt werden, die im Laufe des Sinterprozesses ein Reduktionsmittel freisetzen. Bei diesem Reduktionsmittel handelt es sich vorzugsweise um Kohlenmonoxid. Salze von organischen Säuren, wobei die organischen Säuren 1 - 4 Kohlenstoffatome aufweisen, Ester von organischen Säuren, wobei die organischen Säuren 1 - 4 Kohlenstoffatome aufweisen, und Carbonylkomplexe können als Sinterhilfsmittel dienen, indem sie offensichtlich während des Sinterprozesses Kohlenmonoxid freisetzen und so eine Reduktion der Metalloxide, die auf der Oberfläche der in der Paste enthaltenen Metallpartikel enthalten sind, zu dem entsprechenden Metall bei einer Temperatur von unter 250°C ermöglichen.

Die Eignung von den (b2) Salzen (b3) Estern und (b4) Carbonylkomplexen als Sinterhilfsmittel dienen zu können, geht ebenfalls auf die vorstehend erläuterte Erkenntnis zurück, dass es für das Sintern von Bauelementen unter Verwendung von Pasten einerseits vorteilhaft ist, wenn die in der Paste enthaltenen Partikel, vorzugsweise mit Fettsäuren, gecoatet sind, um eine Agglomeration der Partikel zu vermeiden, dieses Coating aber andererseits ursächlich dafür ist, dass die Sintertemperatur nicht unter 250°C gesenkt werden kann. Die Eignung der nach dieser Ausführungsform verwendeten Verbindungen, als Sinterhilfsmittel dienen zu können, beruht ferner ebenfalls auf der bereits vorstehend erläuterten Erkenntnis, dass die unter der Coatingschicht liegende Oberfläche der Metallpartikel zumeist wenigstens zu einem Teil oxidiert ist und dies die für das Sintern erforderlichen Diffusionsprozesse beeinträchtigt Die Salze, Ester, und Carbonylkomplexe können erfindungsgemäß als Sinterhilfsmittel eingesetzt werden, da sie während dem Sinterprozess Kohlenmonoxid freisetzen bzw. bei deren Verbrennung Kohlenmonoxid entsteht. Das während dem Sintern freigesetzte Kohlenmonoxid ist ein Reduktionsmittel und als solches in der Lage, das auf der Oberfläche der Metallpartikel vorhandene Metalloxid zu reduzieren. Die Entfernung des Metalloxids gewährleistet eine behinderungsfreie Diffusion und damit einhergehend eine Steigerung der Diffusionsgeschwindigkeit. Bei dieser Reduktion des Metalloxids wird außerdem *in situ* reaktives Metall erzeugt, das den Sinterprozess weiter begünstigt. Ferner kann dieses reaktive Metall während des Sinterprozesses zwischen den Metallatomen der Metallpartikel vorhandene Lücken auffüllen und so die Porosität der Kontaktstelle zwischen den zu verbindenden Bauelementen signifikant erniedrigen. Dadurch werden äußerst stabile und wärmeleitfähige sowie elektrisch leitfähige Kontaktstellen erzeugt.

Aus einem bisher noch nicht bekannten Grund scheinen die Salze, Ester und Carbonylkomplexe auch das Abbrennen der auf den Silberpartikeln enthaltenen Coatingverbindungen bei Temperaturen unterhalb von 250°C zu begünstigen. Somit stehen bereits bei Temperaturen von unter 250°C die Oberflächen der Metallpartikel für den Sinterprozess zur Verfügung.

Im Rahmen der Erfindung kann es bevorzugt sein, dass das Salz in der Metallpaste nicht in dissoziierter Form vorliegt. Dementsprechend wird bei einer Ausführungsform der vorliegenden Erfindung, in der als Sinterhilfsmittel das Salz eingesetzt wird, als in der erfindungsgemäßen Paste enthaltenes Lösungsmittel vorzugsweise ein aprotisches Lösungsmittel verwendet.

Bei den Metall-Kationen handelt es sich um Kationen von Metallen, die eine hohe Affinität zu Sauerstoff aufweisen. Es wird angenommen, dass diese Metalle während dem Sinterprozess Sauerstoff binden können und so das Gleichgewicht der Reaktion von mittels Sinterhilfsmittel freigesetztem Kohlenmonoxid mit den auf der Oberfläche der Metallpartikel vorhandenen Metalloxiden zu Kohlendioxid und den Metallen auf die Produktseite verlagern.

Gemäß der Erfindung ist das als Sinterhilfsmittel verwendete wenigstens eine Salz aus der Gruppe ausgewählt, die aus Magnesiumformiat, Aluminiumformiat, Eisen(II)-formiat, Zinn(II)-formiat, Kupfer(II)-formiat, Silber(II)-formiat, und Mangan(III)-formiat, besteht.

Erfindungsgemäß kann als Sinterhilfsmittel auch (b3) ein Ester einer organischen Säure eingesetzt werden, der aus der Gruppe bestehend aus Methylformiat, Ethylformiat, Propylformiat, und Butylformiat ausgewählt ist. Als Sinterhilfsmittel können erfindungsgemäß auch (b4) Carbonylkomplexe eingesetzt werden.

Der Begriff Carbonylkomplexe beschreibt erfindungsgemäß carbonylgruppenhaltige Metallkomplexe, in denen wenigstens ein CO-Molekül koordinativ an wenigstens ein Metallatom gebunden ist.

Neben dem wenigstens einen CO-Molekül können die Carbonylkomplexe auch noch weitere Liganden aufweisen. Bei diesen weiteren Liganden kann es sich um elementare oder molekulare Liganden handeln.

Die Liganden können einzahnig oder mehrzahnig sein.

Bevorzugte elementare Liganden sind Wasserstoff und Halogene. Als Halogene sind Fluor, Chlor, Brom und lod bevorzugt.

Bevorzugte molekulare Liganden sind Stickstoffoxide, Cyanide und organische Liganden.

Bei den organischen Liganden handelt es sich vorzugsweise um ionische oder ungesättigte Liganden.

Als organische Liganden kommen organische Liganden mit wenigstens einem Kohlenstoffatom in Betracht. Vorzugsweise handelt es sich bei den organischen Liganden mit wenigstens einem Kohlenstoffatom um organische Liganden mit 2 - 20, mehr bevorzugt 2 - 16 und noch mehr bevorzugt 2 - 12 Kohlenstoffatomen.

Die organischen Liganden können verzweigt oder unverzweigt sein.

Die organischen Liganden können ferner gesättigt oder einfach oder mehrfach ungesättigt sein.

Die organischen Liganden können ferner eine Ringstruktur aufweisen. In dieser Ringstruktur kann auch wenigstens ein Heteroatom enthalten sein. Dieses wenigstens eine Heteroatom kann vorzugsweise Stickstoff oder Sauerstoff sein.

Bei den organischen Liganden kann es sich auch um aromatische Liganden handeln.

Als ionische Liganden können Alkylliganden, vorzugsweise unverzweigte Alkylliganden, wie zum Beispiel Methylliganden, oder Cyclopentadienyl bevorzugt sein.

Als ungesättigte organische Liganden können Alkene, konjugierte oder nicht konjugierte Diene und Allyle bevorzugt sein. Erfindungsgemäß sind als organische Gruppen auch π-Allyl und Aromaten-Übergangsmetall-Komplexe vorgesehen.

Die erfindungsgemäß eingesetzten Carbonylkomplexe können ein oder mehrere Metallatome enthalten. Weisen die Carbonylkomplexe mehrere Metallatome auf, dann können diese Metallatome gleichartig oder verschiedenartig sein.

Als Metalle der Carbonylkomplexe werden vorzugsweise Metalle verwendet, die eine hohe Affinität zu Sauerstoff aufweisen.

Vorzugsweise weisen die Carbonylkomplexe wenigstens ein Element der Übergangsmetalle, also Elemente der 3. bis 11. Gruppe des Periodensystems der Elemente, auf.

Erfindungsgemäß kann es ferner bevorzugt sein, dass das wenigstens eine Metall der erfindungsgemäß eingesetzten Metallcarbonyle ein Metall ist, das aus der Gruppe ausgewählt ist, die aus Vanadium, Molybdän, Wolfram, Mangan, Eisen, Ruthenium, Osram, Cobalt, und Nickel besteht.

Gemäß einer bevorzugten Ausführungsform handelt es sich bei den Carbonylkomplexen um Metallcarbonyle.

Der Begriff Metallcarbonyle soll im Rahmen der Erfindung Verbindungen beschreiben, die ein- oder mehrkernige Koordinationsverbindungen darstellen, in denen ausschließlich Kohlenmonoxid-Moleküle koordinativ an Metallatome gebunden sind,

Metallcarbonyle können erfindungsgemäß ein Metallatom oder mehrere Metallatome enthalten.

Die in den Metallcarbonylen enthaltenen Metallatome können gleichartig oder verschiedenartig sein.

Vorzugsweise handelt es sich bei den Metallatomen der Metallcarbonyle um Elemente der Übergangsmetalle, also um Elemente der 3. bis 11. Gruppe des Periodensystems der Elemente.

Gemäß einer bevorzugten Ausführungsform handelt es sich bei dem wenigstens einen Metall der erfindungsgemäß eingesetzten Metallcarbonyle um ein Metall, das aus der Gruppe ausgewählt ist, die aus Vanadium, Molybdän, Wolfram, Mangan, Eisen, Ruthenium, Osram, Cobalt, und Nickel besteht.

Das Metallcarbonyl kann ladungsneutral oder als Salz vorliegen. Bei dem Salz kann es sich um ein ein- oder mehrwertiges Salz handeln.

Gemäß einer besonders bevorzugten Ausführungsform ist der erfindungsgemäß als Sinterhilfsmittel eingesetzte Metallkomplex ein Metallkomplex, der aus der Gruppe ausgewählt ist, die aus Vanadiumhexacarbonyl (V(CO)₆), Molybdänhexacarbonyl (Mo(CO)₆), Wolframhexacarbonyl (W(CO)₆), Dimangandecacarbonyl (Mn₂(CO)₁₀), Methylcyclopentadienylmangantricarbonyl ((CH₃C₅H₄)Mn(CO)₃), Eisenpentacarbonyl (Fe(CO)₅), Dieisennonacarbonyl (Fe₂(CO)₉), Trieisendodecacarbonyl (Fe₃(CO)₁₂), Diprototetracarbonylferrat(II) (H₂[Fe(CO)₄]), Dicarbonyldiiodeisen (Fe(CO)₂l₂), Trikaliumcarbonylpentacyanoferrat (K₃[Fe(CN)₅CO], 1,2-Bis-(hexamethylbenzol)-tetracarbonyldieisen (0) (C₁₂H₁₈Fe(CO)₄FeC₁₂H₁₈), Carbidopentaeisenpentadecacarbonyl (Fe₅C(CO)₁₅, Rutheniumpentacarbonyl (Ru(CO)₅, Dirutheniumnonacarbonyl (Ru₂(CO)₉), Trirutheniumdodecacarbonyl (Ru₃(CO)₁₂, Hexarutheniumhexadecacarbonyl (Ru₆(CO)₁₆), Osrampentacarbonyl (Os(CO)₅), Triosramdodecacarbonyl (Os₃(CO)₁₂), Pentaosramhexadecacarbonyl (OS₅(CO)₁₆), Hexaosramoktadecacarbonyl Os₆(CO)₁₈), Dicobaltoktacarbonyl (OS₂(CO)₈), Tetracobaltdodecacarbonyl (OS₄(CO)₁₂), Hexacobalthexadecacarbonyl (Co₆(CO)₁₆), Nickeltetracarbonyl (Ni(CO)₄) Dinatriumcarbonylferrat (Na₂[Fe(CO)₄]) besteht.

Durch den Einsatz der vorstehend beschriebenen Sinterhilfsmittel kann somit die Prozesstemperatur beim Sintern signifikant reduziert werden. Überraschend ist dabei, dass es trotz des Abbrennens der Coatingverbindungen bei Temperaturen von unter 250°C nicht zu einer Agglomeration der Metallpartikel kommt, sondern homogene und stabile Kontaktstellen zwischen den zu verbindenden Bauelementen entstehen.

Gemäß einer besonders bevorzugten Ausführungsform liegt das molare Verhältnis von Sinterhilfsmitteln zu den im Coating der Metallpartikel enthaltenen organischen Verbindungen (Coatingverbindungen) im Bereich von 1 : 1 bis 150 : 1, mehr bevorzugt im Bereich von 3 : 1 bis 100 : 1, noch mehr bevorzugt im Bereich von 5 : 1 bis 80 : 1 und insbesondere im Bereich von 10 : 1 bis 80 : 1. Unter molarem Verhältnis von Sinterhilfsmitteln zu Coatingverbindungen wird erfindungsgemäß der Quotient aus (i) der Summe der Stoffmengen der in der Paste enthaltenen Sinterhilfsmittel und (ii) der Summe der Stoffmengen der im Coating der Metallpartikel enthaltenen Coatingverbindungen bezeichnet. Enthält eine Paste beispielsweise als Sinterhilfsmittel 0,025 mol Aluminiumformiat und 0,015 mol Kupferformiat und als einzige Coatingverbindung 0,0008 mol Kaliumstearat, so beträgt das molare Verhältnis von Sinterhilfsmitteln zu Coatingverbindungen 50: 1.

Ein Verhältnis von Sinterhilfsmitteln zu Coatingverbindungen im erfindungsgemäß bevorzugten Bereich hat weitere vorteilhafte Effekte zur Folge. So wird dadurch einerseits gewährleistet, dass während des Sinterprozesses als Resultat des Verbrennens der Coatingverbindungen genügend Kohlenmonoxid zur Reduktion der Metalloxide zur Verfügung steht. Andererseits ist die Menge an Sinterhilfsmitteln dann noch nicht so hoch, dass hierdurch der Sinterprozess beeinträchtigt würde. Wie vorstehend erläutert, kann es erfindungsgemäß bevorzugt sein, wenn es sich bei den im Coating der Metallpartikel enthaltenen organischen Verbindungen um freie Fettsäuren, Fettsäuresalze oder Fettsäureester handelt, die vorzugsweise 10 - 24 und mehr bevorzugt 12 - 18 Kohlenstoffatome aufweisen.

Die vorstehend beschriebenen Effekte scheinen im Ergebnis dazu zu führen, dass es bei Verwendung der eingesetzten Sinterhilfsmittel gelingt, die Sintertemperatur auf unter 250°C zu erniedrigen und trotzdem stabile und wärmeleitfähige sowie elektrisch leitfähige Kontaktstellen zwischen den durch den Sinterprozess zu verbindenden Bauelementen zu erzeugen.

Gemäß einer bevorzugten Ausführungsform enthält die Paste wenigstens einen Metallprecursor.

Unter Metallprecursor wird im Rahmen der Erfindung eine Verbindung verstanden, die bei Temperaturen von unter 250°C in Gegenwart der in der Paste enthaltenen Metallpartikel zu dem Metall des Metallprecursors zersetzt wird. Vorzugsweise wird demnach bei Verwendung eines Metallprecursors beim Sinterprozess *in situ* ein Metall gebildet. Es kann auf einfache Weise ermittelt werden, ob es sich bei einer Verbindung um einen Metallprecursor gemäß dieser bevorzugten Ausführungsform handelt. So kann beispielsweise eine Paste, die eine zu testende Verbindung enthält, auf ein Substrat mit einer Silberoberfläche abgeschieden, auf 250°C erhitzt und bei dieser Temperatur für 20 Minuten belassen werden. Danach wird überprüft, ob sich unter diesen Bedingungen die zu testende Verbindung zu einem Metall zersetzt hat. Hierzu kann beispielsweise vor dem Test der Gehalt der metallhaltigen Pastenbestandteile ausgewogen und daraus die theoretische Masse des Metalls berechnet werden. Nach dem Test wird die Masse des auf dem Substrat abgeschiedenen Materials gravimetrisch bestimmt. Entspricht die Masse des auf dem Substrat abgeschiedenen Materials der theoretischen Masse des Metalls, wobei die üblichen Messabweichungen zu berücksichtigen sind, handelt es sich bei der getesteten Verbindung um einen Metallprecursor gemäß dieser bevorzugten Ausführungsform.

Gemäß einer weiteren bevorzugten Ausführungsform weist der Metallprecursor ein Metall auf, das auch in den Metallpartikeln enthalten ist. Gemäß einer besonders bevorzugten Ausführungsform weist der Metallprecursor daher Silber oder Kupfer als Metall auf.

Es kann bevorzugt sein, als Metallprecursor Metallcarbonate, Metalllactate, Metallformiate, Metallcitrate, Metalloxide oder Metall-Fettsäuresalze, vorzugsweise Fettsäuresalze mit 6 bis 24 Kohlenstoffatomen zu verwenden.

In besonderen Ausführungsformen werden als Metallprecursor Silbercarbonat, Silber(1)-lactat, Silber(II)-formiat, Silbercitrat, Silberoxid (zum Beispiel AgO oder Ag₂O), Kupfer(II)-lactat, Kupferstearat, Kupferoxide (zum Beispiel Cu₂O oder CuO) oder Goldoxide (zum Beispiel Au₂O oder AuO) eingesetzt.

Gemäß einer besonders bevorzugten Ausführungsform wird der Metallprecursor aus der Gruppe ausgewählt, die aus Silbercarbonat und Silberoxiden besteht.

Falls vorhanden, liegt der Metallprecursor in der Paste vorzugsweise in partikulärer Form, besonders bevorzugt in der Form von Flakes, vor.

Die Verwendung eines Metallprecursors, der während des Sinterprozesses *in situ* Metall freisetzt, hat zur Folge, dass das *in situ* gebildete Metall während des Sinterprozesses Lücken zwischen den in der Paste enthaltenen Metallpartikeln schließt. Auf diese Weise kann die Porosität einer Kontaktstelle zwischen zwei zu verbindenden Bauelementen reduziert werden.

Die Paste enthält, zumindest im nicht verfestigten Zustand, ferner wenigstens eine Verbindung, die als Lösungsmittel wirken kann. Hierfür kommen die üblicherweise für Metallpasten verwendeten Lösungsmittel in Betracht. Beispielsweise können als Lösungsmittel α-Terpineol ((R)-(+)-α-Terpineol, (S)-(-)-α-Terpineol oder Racemate), β-Terpineol, γ-Terpineol, δ-Terpineol, Mischungen der vorstehend genannten Terpineole, N-Methyl-2-pyrrolidon, Ethylenglycol, Dimethylacetamid, 1-Tridecanol, 2-Tridecanol, 3-Tridecanol, 4-Tridecanol, 5-Tridecanol, 6-Tridecanol, Isotridecanol, dibasische Ester (vorzugsweise Dimethylester der Glutar-, Adipin- oder Bernsteinsäure oder Mischungen davon), Glycerin, Diethylenglycol, Triethylenglycol oder Mischungen hiervon zum Einsatz kommen.

Die Paste kann ferner wenigstens ein Polymer enthalten, um der Paste gewünschte Eigenschaften zu verleihen. Andererseits kann es jedoch von Vorteil sein, dass die Paste keine Polymere enthält oder deren Anteil gering ist, da Polymere, insbesondere Duroplasten, üblicherweise bei Temperaturen von mehr als 250°C ausbrennen und sich daher nachteilig auf die Sinterfähigkeit der Paste auswirken. Dies gilt insbesondere für Duroplasten oder Vorprodukte davon. Unter Vorprodukten von Duroplasten werden Verbindungen verstanden, die in Gegenwart weiterer Pastenbestandteile zu Duroplasten aushärten können. Diese Duroplasten oder Vorprodukte davon weisen üblicherweise ein gewichtsmittleres Molekulargewicht von weniger als 700 auf. Gemäß einer bevorzugten Ausführungsform beträgt der Anteil an Polymeren, die ein gewichtsmittleres Molekulargewicht von weniger als 700 aufweisen, nicht mehr als 6 Gewichtsprozent, bezogen auf das Gesamtgewicht der Paste.

Darüber hinaus können in der Metallpaste weitere Inhaltsstoffe, wie zum Beispiel übliche Dispersionsmittel, Tenside, Entschäumer, Bindemittel oder viskositätssteuernde Mittel, enthalten sein.

Die erfindungsgemäß eingesetzte Paste wird auf eine Oberfläche eines Trägers aufgebracht, um wenigstens ein Strukturelement zu erzeugen. Diese Strukturelemente auf der Oberfläche des Trägers weisen daher zunächst noch nicht verfestigte Paste auf, die anschließend verfestigt wird.

Das Aufbringen der Paste auf die Oberfläche des Trägers erfolgt dabei derart, dass das gewünschte Muster aus Strukturelementen, die die Paste enthalten, auf der Oberfläche des Trägers geschaffen wird.

Das Aufbringen der Paste auf die Oberfläche des Trägers kann dabei mittels herkömmlicher Verfahren erfolgen. Vorzugsweise wird die Paste durch ein Druckverfahren, beispielsweise durch Siebdruck oder Schablonendruck, aufgetragen.

Die Abstände zwischen den einzelnen Strukturelementen aus Paste werden vorzugsweise so gewählt, dass ein Muster erzeugt wird, das dem Muster entspricht, mit dem die später auf der Sintervorform nebeneinander angeordneten Bauelemente nach dem Sintervorgang auf dem zu verbindenden Bauelement angeordnet sind.

Die Geometrie der aufgetragenen Paste wird vorzugsweise so gewählt, dass nach dem Verfestigen der Paste ein Strukturelement erhalten wird, das in der Lage ist, so mit einem Bauelement bestückt zu werden, dass ein gewünschter Bereich der Oberfläche des Bauelements mit Paste in Kontakt steht. Dabei ist es möglich, dass nur ein Teil der Oberfläche oder die gesamte Oberfläche des Bauelements, mit dem das Strukturelement bestückt wird, mit dem Strukturelement in Kontakt steht.

Die Dicke der aufgetragenen Paste wird vorzugsweise an die Dimensionen der zu verbindenden Bauelemente angepasst. Soll beispielsweise ein erster Halbleiterchip mit einer ersten Kontaktfläche eines Leadframes verbunden werden, die sich in einer Aussparung befindet, und ein zweiter Halbleiterchip mit der zweiten Kontaktfläche eines Leadframes verbunden werden, die sich nicht in einer Aussparung befindet, so kann zur Erzeugung des Strukturelements, über das der erste Halbleiterchip mit der ersten Kontaktfläche des Leadframes verbunden werden soll, eine größere Auftragsdicke für die Paste gewählt werden als zur Erzeugung des Strukturelements, über das der zweite Halbleiterchip mit der zweiten Kontaktfläche des Leadframes verbunden werden soll. Dadurch kann eine Struktur geschaffen werden, die je nach Abstand der zu verbindenden Bauelemente Strukturelemente mit unterschiedlichen Höhen aufweist.

Die Auftragsdicke der Paste ist nicht weiter eingeschränkt. Üblicherweise liegt sie im Bereich von 10 - 300 µm, vorzugsweise im Bereich von 10 - 200 µm und besonders bevorzugt im Bereich von 20 - 50 µm.

Die erfindungsgemäß eingesetzte Paste wird zur Erzeugung des wenigstens einen Strukturelements auf der Oberfläche des Trägers verfestigt. Im Rahmen der Erfindung wird die Paste verfestigt, wenn ihr eine Konsistenz verliehen wird, mit der die Paste gravitationsbedingt keiner Formveränderung unterliegt.

Das Verfestigen der Paste erfolgt vorzugsweise durch Entfernen der bei Raumtemperatur flüssigen Bestandteile der Paste, insbesondere der Lösungsmittel. Zum Entfernen der bei Raumtemperatur flüssigen Bestandteile wird die Paste vorzugsweise getrocknet.

Unter Trocknen wird demgemäß das Entfernen des in der Paste enthaltenen, wenigstens einen Lösungsmittels verstanden. Das Entfernen des Lösungsmittels kann quantitativ erfolgen. Andererseits ist es jedoch auch möglich, dass noch Reste an Lösungsmitteln in der Paste verbleiben. Erfindungsgemäß werden beim Trocknen wenigstens 99,5 Gewichtesprozent, mehr bevorzugt wenigstens 99,7 Gewichtsprozent und noch mehr bevorzugt wenigstens 99,9 Gewichtsprozent der Lösungsmittel, bezogen auf das Gewicht des ursprünglich in der Paste vorhandenen Lösungsmittels, entfernt. Erfindungsgemäß enthält die verfestigte Paste nicht mehr als 0,5 Gewichtsprozent, mehr bevorzugt nicht mehr als 0,4 Gewichtsprozent, noch mehr bevorzugt nicht mehr als 0,3 Gewichtsprozent, besonders bevorzugt nicht mehr als 0,2 Gewichtsprozent und ganz besonders bevorzugt nicht mehr als 0,1 Gewichtsprozent an Lösungsmitteln, bezogen auf das Gewicht der getrockneten Paste.

Besonders bevorzugt ist es, dass die verfestigte Paste nicht mehr als 0,5 Gewichtsprozent, mehr bevorzugt nicht mehr als 0,4 Gewichtsprozent, noch mehr bevorzugt nicht mehr als 0,3 Gewichtsprozent, besonders bevorzugt nicht mehr als 0,2 Gewichtsprozent und ganz besonders bevorzugt nicht mehr als 0,1 Gewichtsprozent an Verbindungen, die bei einer Temperatur von 25°C und einem Druck von 1013 hPa flüssig sind, bezogen auf das Gewicht der getrockneten Paste, enthält. Erfindungsgemäß enthält die verfestigte Paste 75 - 95 Gewichtsprozent Metallpartikel, 0,1 - 15 Gewichtsprozent Sinterhilfsmittel, 0 - 0,5 Gewichtsprozent Lösungsmittel, 0 - 12 Gewichtsprozent Metallprecursor und 0 - 10 Gewichtsprozent weitere Bestandteile, bezogen auf das Gewicht der verfestigten Paste.

Gemäß einer besonders bevorzugten Ausführungsform enthält die verfestigte Paste 80 - 95 Gewichtsprozent Metallpartikel, 2 - 15 Gewichtsprozent Sinterhilfsmittel, 0 - 0,3 Gewichtsprozent Lösungsmittel, 0 - 12 Gewichtsprozent Metallprecursor und 0 - 10 Gewichtsprozent weitere Bestandteile, bezogen auf das Gewicht der verfestigten Paste.

Gemäß einer ganz besonders bevorzugten Ausführungsform enthält die verfestigte Paste 80 - 95 Gewichtsprozent Metallpartikel, 3 - 15 Gewichtsprozent Sinterhilfsmittel, 0 - 0,1 Gewichtsprozent Lösungsmittel, 0 - 12 Gewichtsprozent Metallprecursor und 0 - 10 Gewichtsprozent weitere Bestandteile, bezogen auf das Gewicht der verfestigten Paste.

Die Verfestigung der Paste, vorzugsweise die Trocknung der Paste, erfolgt unter Bedingungen, die gewährleisten, dass es nicht zu einer vollständigen Versinterung der Paste kommt. Erforderlich ist demnach, dass die verfestigte Paste zumindest eine Restreaktivität für den später folgenden Sinterprozess aufweist. Es kann jedoch durchaus vorteilhaft sein, dass für die Trocknung Bedingungen gewählt werden, unter denen es bereits zu einer Teilversinterung der Paste kommt. Dies kann beispielsweise gewünscht sein, um die Stabilität der Paste sowie die Adhäsion der Paste auf dem Substrat zu erhöhen. Die Stabilität der Paste sowie die Adhäsion der Paste auf dem Substrat werden offenbar zusätzlich erhöht durch die wenigstens eine organische Verbindung, die sich als Coating auf den Metallpartikeln befindet. Dies ist wohl darauf zurückzuführen, dass sich bei einer Temperaturerhöhung geringe Mengen der Coatingverbindungen ablösen und als Haftvermittler zwischen den Metallpartikeln der Paste oder zwischen den Metallpartikeln der Paste und dem Träger dienen.
Das Trocknen der Paste erfolgt demnach vorzugsweise bei einer Temperatur, einem Druck, einer Luftfeuchtigkeit und für eine Dauer, die geeignet sind, die Lösungsmittel aus der Paste weitestgehend zu entfernen, ohne dass jedoch nach dem Trocknen die Sinterprozesse innerhalb der Paste bereits vollständig abgelaufen sind.

Vorzugsweise erfolgt die Trocknung bei Temperaturen unterhalb von 200°C und mehr bevorzugt unterhalb von 150°C und beispielsweise bei etwa 120°C für eine Dauer von vorzugsweise 3 - 60 Minuten. Zum Trocknen können übliche Trocknungsapparaturen eingesetzt werden.

Beim Verfestigen der Paste kommt es üblicherweise zu einer Erhöhung der Porosität der Paste. Es hat sich überraschenderweise gezeigt, dass das Anbinden des Strukturelements aus verfestigter Paste an das zu bestückende Bauelement auf besonders einfache Weise erfolgen kann, wenn die Porosität der verfestigten Paste erhöht ist. Unter Porosität wird hierin der Volumenanteil von Poren, bezogen auf das Volumen der verfestigten Paste, verstanden. Gemäß einer bevorzugten Ausführungsform beträgt die Porosität der verfestigten Paste vorzugsweise wenigstens 20 Volumenprozent, mehr bevorzugt wenigstens 40 Volumenprozent, noch mehr bevorzugt wenigstens 60 Volumenprozent, besonders bevorzugt wenigstens 80 Volumenprozent und ganz besonders bevorzugt wenigstens 90 Volumenprozent. Die Porosität der verfestigten Paste kann auf einfache Weise über den Anteil und die Art des in der Paste enthaltenen Lösungsmittels, die Trocknungsdauer und die Trocknungstemperatur eingestellt werden.

Auf dem wenigstens einen Strukturelement, das die verfestigte Paste enthält, kann ferner eine Folie aufgebracht sein. Diese Folie kann insbesondere dazu dienen, das Strukturelement vor Beschädigungen, beispielsweise durch mechanische Beanspruchung, zu bewahren. Vorzugsweise bedeckt die Folie die gesamte, aus den einzelnen Strukturelementen gebildete Struktur auf der Oberfläche des Trägers der Sintervorform. Bei der Folie kann es sich beispielsweise um eine Folie aus Polymer oder um ein Papier handeln. Falls eine Folie auf dem wenigstens einen Strukturelement vorhanden ist, wird diese während der Durchführung des erfindungsgemäßen Verfahrens entfernt. Die Entfernung der Folie erfolgt, bevor das wenigstens eine Strukturelement auf der Oberfläche der Sintervorform, das die verfestigte Paste enthält, mit der zu verbindenden Oberfläche des ersten Bauelements kontaktiert wird.

Erfindungsgemäß werden wenigstens zwei Bauelemente miteinander verbunden. Diese weisen jeweils wenigstens eine zu verbindende Oberfläche auf. Unter zu verbindender Oberfläche eines Bauelements wird hierin eine Oberfläche eines Bauelements verstanden, die mit der Oberfläche eines weiteren Bauelements durch Sintern verbunden werden soll.

Die wenigstens zwei zu verbindenden Bauelemente werden hierin als erstes Bauelement bzw. als zweites Bauelement bezeichnet. Die Begriffe "erstes" und "zweites" dienen hierbei nur dazu, die zu verbindenden Bauelemente begrifflich zu unterscheiden. Insbesondere werden dadurch keine Vorgaben hinsichtlich Art und Form der Bauelemente gemacht.

Zum Verbinden wird das wenigstens eine Strukturelement auf der Oberfläche des Trägers der Sintervorform mit der zu verbindenden Oberfläche des ersten Bauelements in Kontakt gebracht.

Beim Kontaktieren des wenigstens einen Strukturelements auf der Oberfläche des Trägers der Sintervorform mit der zu verbindenden Oberfläche des ersten Bauelements wird somit eine Anordnung aus dem ersten Bauelement und dem wenigstens einen Strukturelement geschaffen, die mit dem Träger in Kontakt steht. Diese Anordnung steht mit dem Träger über das wenigstens eine Strukturelement in Kontakt, wobei üblicherweise aufgrund von Adhäsionskräften eine Haftung der Anordnung auf dem Träger gewährleistet ist.

Vorzugsweise sind auf der Oberfläche des Trägers der Sintervorform mehrere Strukturelemente angeordnet. In diesem Fall ist es bevorzugt, dass mehrere Strukturelemente auf der Oberfläche des Trägers der Sintervorform, besonders bevorzugt alle Strukturelemente auf der Oberfläche des Trägers der Sintervorform, mit Bauelementen, darunter dem ersten Bauelement, versehen werden. Vorzugsweise wird auf jedem Strukturelement ein anderes Bauelement angeordnet. Demgemäß werden vorzugsweise mehrere Strukturelemente auf der Oberfläche des Trägers der Sintervorform, besonders bevorzugt alle Strukturelemente auf der Oberfläche des Trägers der Sintervorform, unabhängig voneinander mit Bauelementen versehen. Diese Bauelemente sind vorzugsweise nebeneinander in einer Ebene angeordnet.

Gemäß einer bevorzugten Ausführungsform wird das erste Bauelement mit dem auf der Oberfläche des Trägers der Sintervorform angeordneten, wenigstens einen Strukturelement so kontaktiert, dass eine auf dem ersten Bauelement eventuell vorhandene Metallisierungsschicht mit dem Strukturelement in Kontakt steht. Werden mehrere Bauelemente nebeneinander mit mehreren Strukturelementen in Kontakt gebracht, erfolgt die Kontaktierung vorzugsweise ebenfalls derart, dass gegebenenfalls auf den einzelnen Bauelementen vorhandene Metallisierungsschichten mit den Strukturelementen in Kontakt stehen.

Die Kontaktierung des wenigstens einen Strukturelements mit der zu verbindenden Oberfläche des ersten Bauelements, vorzugsweise die Kontaktierung mehrerer Strukturelemente unabhängig voneinander mit den zu verbindenden Oberflächen einzelner Bauelemente, erfolgt gemäß einer bevorzugten Ausführungsform durch Anpressen. Dabei kann einerseits die das Strukturelement aufweisende Sintervorform auf die zu verbindende Oberfläche des ersten Bauelements gepresst werden, so dass das Strukturelement und die zu verbindende Oberfläche des ersten Bauelements miteinander verbunden werden. Andererseits kann auch die zu verbindende Oberfläche des ersten Bauelements auf das wenigstens eine Strukturelement der Sintervorform gepresst werden.

Dieses Anpressen macht keine besonderen Maßnahmen erforderlich. Vorzugsweise erfolgt das Anpressen bei Temperaturen unterhalb der Sintertemperatur und mehr bevorzugt bei Temperaturen unterhalb von 200°C, so zum Beispiel bei Temperaturen im Bereich von 100 - 200°C. Dabei kann es bevorzugt sein, die mit wenigstens dem ersten Bauelement versehene Sintervorform auf die gewünschte Anpresstemperatur zu erwärmen. Das Anpressen kann unter moderatem Druck, vorzugsweise bei einem Druck von wenigstens 0,1 N/mm², mehr bevorzugt bei einem Druck von wenigstens 0,5 N/mm², noch mehr bevorzugt bei einem Druck von wenigstens 1,0 N/mm² und besonders bevorzugt bei einem Druck von wenigstens 2 N/mm² erfolgen. Für das Anpressen können herkömmliche Stempelvorrichtungen oder Pressvorrichtungen zum Einsatz kommen.

Das Anpressen erfolgt vorzugsweise dergestalt, dass eine Haftung zwischen dem wenigstens einen Strukturelement und dem ersten Bauelement erreicht wird, die ein einfaches Entfernen der Anordnung aus dem ersten Bauelement und dem wenigstens einen Strukturelement von dem Träger der Sintervorform ermöglicht.

Nach der Kontaktierung des wenigstens einen Strukturelements mit der zu verbindenden Oberfläche des ersten Bauelements liegt somit eine mit dem Träger in Kontakt stehende, vorzugsweise auf dem Träger haftende Anordnung vor, die das wenigstens eine Strukturelement und wenigstens das erste Bauelement aufweist, wobei die gegebenenfalls auf der Oberfläche des ersten Bauelements enthaltene Metallisierungsschicht mit dem Strukturelement in Kontakt steht.

Anschließend wird die Anordnung aus dem ersten Bauelement und dem wenigstens einen Strukturelement von dem Träger entfernt. Dazu kann einerseits der Träger, der das sich nun auf wenigstens dem ersten Bauelement befindliche wenigstens eine Strukturelement bedeckt, von dem wenigstens einen Strukturelement der Sintervorform abgezogen werden. Vorzugsweise wird der Träger dann von allen Strukturelementen der Sintervorform entfernt. Andererseits kann auch die Anordnung aus dem ersten Bauelement und dem wenigstens einen Strukturelement von dem Träger abgehoben werden. Dies ist möglich, da die Haftung zwischen dem ersten Bauelement und dem wenigstens einen Strukturelement größer ist als die Haftung zwischen der Anordnung und dem Träger.

Nach dem Entfernen der Anordnung aus dem ersten Bauelement und dem wenigstens einen Strukturelement vom Träger steht das mit dem ersten Bauelement in Verbindung stehende Strukturelement für die Kontaktierung mit dem zweiten Bauelement zur Verfügung. Waren auf der Sintervorform mehrere Strukturelemente vorhanden, so stehen nach dem Entfernen der Anordnungen vom Träger dementsprechend mehrere mit Bauelementen versehene Strukturelemente für die Kontaktierung mit dem zweiten Bauelement zur Verfügung.

Anschließend wird erfindungsgemäß die zu verbindende Oberfläche des zweiten Bauelements mit dem wenigstens einen Strukturelement der Anordnung aus dem ersten Bauelement und dem wenigstens einen Strukturelement kontaktiert, um eine Sinteranordnung aus erstem Bauelement, zweiten Bauelement und dazwischen angeordnetem Strukturelement zu schaffen.

Gemäß einer bevorzugten Ausführungsform wird die zu verbindende Oberfläche des zweiten Bauelements mit dem wenigstens einen Strukturelement derart kontaktiert, dass eine gegebenenfalls auf der Oberfläche des zweiten Bauelements vorhandene Metallisierungsschicht mit dem wenigstens einen Strukturelement in Kontakt steht. Dabei wird vorzugsweise eine Sinteranordnung geschaffen, die das erste Bauelement mit einer Metallisierungsschicht, das zweite Bauelement mit einer Metallisierungsschicht und einem dazwischen angeordnetem Strukturelement aufweist, wobei die Metallisierungsschicht des ersten Bauelements und die Metallisierungsschicht des zweiten Bauelements über das Strukturelement miteinander in Verbindung stehen.

Gemäß einer weiteren bevorzugten Ausführungsform kann auch die zu verbindende Oberfläche des zweiten Bauelements bereits wenigstens ein Strukturelement aufweisen. Dieses Strukturelement kann beispielsweise dadurch erzeugt werden, dass eine hierin beschriebene Sintervorform bereitgestellt wird, das wenigstens eine Strukturelement auf der Oberfläche des Trägers der Sintervorform mit der zu verbindenden Oberfläche des zweiten Bauelements kontaktiert wird, und die Anordnung aus dem zweiten Bauelement und dem Strukturelement vom Träger der Sintervorform entfernt wird. Gemäß dieser Ausführungsform weisen sowohl das erste Bauelement als auch das zweite Bauelement bereits wenigstens ein Strukturelement auf. Diese Strukturelemente des ersten Bauelements und des zweiten Bauelements können schließlich kontaktiert werden, um eine Sinteranordnung aus erstem Bauelement, zweitem Bauelement und dazwischen angeordnetem Strukturelement zu schaffen. In diesem Fall stammt ein Teil des Strukturelements von der Kontaktierung einer Sintervorform mit dem ersten Bauelement und ein anderer Teil des Strukturelements von der Kontaktierung einer anderen Sintervorform mit dem zweiten Bauelement. Wenn nachstehend von der Oberfläche des zweiten Bauelements die Rede ist, so ist hiervon auch der Fall umfasst, dass das zweite Bauelement gemäß der vorstehend beschriebenen Ausführungsform bereits ein Strukturelement aufweist. Somit kann beim erfindungsgemäßen Verfahren die zu verbindende Oberfläche des zweiten Bauelements mit dem wenigstens einen Strukturelement der Anordnung aus dem ersten Bauelement und dem wenigstens einen Strukturelement auch über ein weiteres Strukturelement kontaktiert werden, das Teil einer Anordnung aus dem zweiten Bauelement und diesem Strukturelement ist.

Das Kontaktieren der zu verbindenden Oberfläche des zweiten Bauelements mit dem wenigstens einen Strukturelement erfolgt vorzugsweise durch Anpressen. Dabei kann einerseits die Anordnung, die das erste Bauelement und das Strukturelement aufweist, auf die zu verbindende Oberfläche des zweiten Bauelements gepresst werden, so dass das erste Bauelement über das Strukturelement mit der zu verbindenden Oberfläche des zweiten Bauelements verbunden ist. Andererseits kann auch die zu verbindende Oberfläche des zweiten Bauelements auf das mit dem ersten Bauelement verbundene Strukturelement gepresst werden.

Dieses Anpressen macht keine besonderen Maßnahmen erforderlich. Vorzugsweise erfolgt das Anpressen bei Temperaturen unterhalb der Sintertemperatur und mehr bevorzugt bei Temperaturen unterhalb von 200°C, so zum Beispiel bei Temperaturen im Bereich von 100 - 200°C. Dabei kann es bevorzugt sein, die Anordnung aus ersten Bauelement und dem wenigstens einen Strukturelement vor dem Kontaktieren auf eine Temperatur im Bereich von 100 - 200°C zu erwärmen. Es kann ebenfalls bevorzugt sein, das zweite Bauelement vor dem Kontaktieren auf eine Temperatur im Bereich von 100 - 200°C zu erwärmen. Besonders bevorzugt kann es sein, sowohl die Anordnung aus ersten Bauelement und dem wenigstens einen Strukturelement als auch das zweite Bauelement vor dem Kontaktieren auf eine Temperatur im Bereich von 100 - 200°C zu erwärmen. Das Anpressen kann unter moderatem Druck, vorzugsweise bei einem Druck von wenigstens 0,1 N/mm², mehr bevorzugt bei einem Druck von wenigstens 0,5 N/mm², noch mehr bevorzugt bei einem Druck von wenigstens 1,0 N/mm² und besonders bevorzugt bei einem Druck von wenigstens 2 N/mm² erfolgen. Für das Anpressen können herkömmliche Stempelvorrichtungen oder Pressvorrichtungen verwendet werden.

Die Sinteranordnung aus erstem Bauelement, zweiten Bauelement und dazwischen angeordnetem Strukturelement wird schließlich gesintert.

Bei diesem Sinterprozess handelt es sich um einen Niedertemperatursinterprozess. Unter Niedertemperatursinterprozess ist erfindungsgemäß ein Sinterprozess zu verstehen, der vorzugsweise bei einer Temperatur von unter 250°C, mehr bevorzugt bei einer Temperatur von unter 220°C, noch mehr bevorzugt bei einer Temperatur von unter 200°C und besonders bevorzugt bei einer Temperatur von unter 180°C abläuft.

Der Prozessdruck beim Sintern liegt vorzugsweise unter 30 MPa, mehr bevorzugt unter 5 MPa und noch mehr bevorzugt unter 1 MPa. Aufgrund der Verwendung der erfindungsgemäßen Paste gelingt das Sintern sogar ohne jegliche Anwendung von Prozessdruck, also bei einem Prozessdruck von 0 MPa.

Die Sinterzeit ist abhängig vom Prozessdruck und liegt vorzugsweise im Bereich von 2 - 45 Minuten.

Erfindungsgemäß kann der Sinterprozess in einer Atmosphäre erfolgen, die nicht weiter eingeschränkt ist. Vorzugsweise wird das Sintern jedoch in einer Atmosphäre durchgeführt, die Sauerstoff enthält.

Das Sintern wird in einer herkömmlichen, zum Sintern geeigneten Vorrichtung durchgeführt, in der sich vorzugsweise die vorstehend beschriebenen Prozessparameter einstellen lassen.

Das vorstehend beschriebene Verfahren zum Verbinden wenigstens zweier Bauelemente ermöglicht eine prozessökonomisch vorteilhafte und zumindest teilweise parallele Verarbeitung einer Mehrzahl von Bauelementen, eine strukturierte Ausgestaltung der Sinterschicht sowie eine Erniedrigung der Sintertemperatur auf unter 250°C.

In prozessökonomischer Hinsicht ist das erfindungsgemäße Verfahren insbesondere deshalb vorteilhaft, weil die Herstellung der Verbindung unter Verwendung einer bereits verfestigten Paste erfolgt. Somit ist erfindungsgemäß unmittelbar vor dem Sintern keine Trocknung der Paste mehr erforderlich. Dadurch kann eine wesentliche Verkürzung der Prozesszeiten erreicht werden. Ferner ist auf Anwenderseite keine Applikation der Paste erforderlich. Diese Applikation erfolgt herkömmlicherweise mit besonderen Applikationsvorrichtungen, wobei immer Abfall entsteht, der zumeist edelmetallhaltig ist. Erfindungsgemäß erübrigt sich auf Anwenderseite sowohl das Problem der Abfallentsorgung bzw. Abfallaufbereitung als auch die aufwändige Reinigung der Applikationsvorrichtungen.

Da erfindungsgemäß die Verfestigung der Paste bereits vor dem Kontaktieren der Bauelemente erfolgt, entsteht beim Kontaktieren der Bauelemente über das Strukturelement eine sehr homogene, lunkerfreie Schicht. Dadurch kann die Zuverlässigkeit der geschaffenen Verbindung wesentlich verbessert werden.

Dadurch, dass die einzelnen Strukturelemente auf dem Träger der Sintervorform vordimensioniert und mit unterschiedlichen Geometrien und Dicken gefertigt werden können, ist es möglich, Verbindungen mit Kontaktflächen von Bauelementen zu erzeugen, selbst wenn diese Kontaktflächen nicht in einer Ebene liegen. Insbesondere können damit auch gebogene Leadframes oder Leadframes mit Wannenform mit den entsprechenden Bauelementen verbunden werden.

Durch die Möglichkeit einer einheitlichen Dimensionierung bezüglich der Dicke, der Geometrie, der Zusammensetzung und des Volumens der einzelnen Strukturelemente bzw. der Struktur, können reproduzierbare Eigenschaften der Kontaktschicht zwischen den zu verbindenden Bauelementen erreicht werden, die die Verwendung des erfindungsgemäßen Verfahrens für Anwendungen gestatten, in denen ein Höchstmaß an Präzision gefordert ist.

Ein ganz wesentlicher Vorteil des erfindungsgemäßen Verfahrens besteht darin, dass die zum Sintern erforderliche Temperatur durch den Einsatz der Sinterhilfsmittel in den verfestigten Pasten erheblich reduziert werden kann.

### Beispiele:

### Beispiel 1:

Durch Verrühren von Mischungen mit den folgenden Zusammensetzungen wurden homogene Metallpasten hergestellt, die als Pasten 1 - 4 bezeichnet wurden:

| | Paste 1 | Paste 2 | Paste 3 | Paste 4 |
|---|---|---|---|---|
| Silber | 83 Gew.% | 83 Gew.% | 83 Gew.% | 80 Gew.% |
| Aluminiumformiat | - | - | 5 Gew.% | 5 Gew.% |
| Silbercarbonat | - | - | - | 5 Gew.% |
| Terpineol | 17 Gew.% | 9 Gew.% | 12 Gew.% | 10 Gew.% |
| Tridecanol | - | 8 Gew.% | - | - |

Die Pasten 1 - 4 wurden in getrennten Versuchen als definierte Strukturelemente mit einer Dicke von 50 µm auf eine Polyesterfolie aufgetragen und anschließend bei einer Temperatur von 100°C für eine Zeitdauer von 10 Minuten getrocknet, um die Sintervorformen 1 - 4 zu erhalten, die jeweils einen Träger (Polyesterfolie) mit Strukturelementen aus verfestigter Paste 1 - 4 enthielten.

Anschließend wurden Chips, die eine Nickel-Silber-Metallisierung und eine Fläche von 25 mm² aufwiesen, mit einem Druck von 2 MPa auf die Strukturelemente der einzelnen Sintervorformen 1 - 4 gesetzt. Dabei wurden Anordnungen aus Chip und Strukturelement erhalten, die mit dem Träger in Kontakt standen. Danach wurden die Anordnungen aus Chip und Strukturelement vom Träger abgehoben und auf die Nickel-Gold-Metallisierung eines DCB (*Direct Copper Bonded*) -Substrats gesetzt. Diese Sandwichanordnung aus DCB-Substrat, Chip und dazwischenliegendem Strukturelement wurde im Anschluss zwischen zwei Heizplatten bei einer Temperatur von 200°C und einem Druck von 10 MPa für eine Zeitdauer von 2 Minuten gesintert.

### Ergebnis von Beispiel 1:

Die Scherfestigkeiten der in Beispiel 1 erhaltenen Kontaktschichten zwischen DCB-Substrat und Chip wurden mittels eines herkömmlichen Schertests bestimmt.

Die Ergebnisse des Schertests sind in der nachfolgenden Tabelle zusammengefasst:

| Sintervorform | 1 | 2 | 3 | 4 |
|---|---|---|---|---|
| Scherfestigkeit | Sehr gering | Sehr gering | Hoch | Sehr hoch |
| Anmerkung | Praktisch keine Verbindung zwischen Chip und Substrat möglich | Praktisch keine Verbindung zwischen Chip und Substrat möglich; Scherfestigkeit aber etwas höher als bei #1 | Stabile Verbindung zwischen Chip und Substrat; Scherfestigkeit deutlich höher als bei #1 und #2 | Sehr stabile Verbindung zwischen Chip und Substrat; Scherfestigkeit deutlich höher als bei #1 und #2; Scherfestigkeit etwas höher als bei #3 |

Es stellte sich heraus, dass der Zusatz von Aluminiumformiat zu einer signifikanten Erhöhung der Scherfestigkeit der unter Verwendung der Sintervorformen erhaltenen Kontaktschichten zwischen Chip und Substrat führte. Eine noch stabilere Verbindung wurde durch den gemeinsamen Zusatz von Aluminiumformiat und Silbercarbonat erreicht.

### Beispiel 2: (ein Referenzbeispiel, das nicht der Erfindung entspricht)

Durch Verrühren von Mischungen mit den folgenden Zusammensetzungen wurden homogene Metallpasten hergestellt, die als Pasten 5 und 6 bezeichnet wurden:

| | Paste 5 | Paste 6 |
|---|---|---|
| Silber | 80 Gew.% | 80 Gew.% |
| Dicumylperoxid | - | 5 Gew.% |
| Silbercarbonat | 5 Gew.% | 5 Gew.% |
| Terpineol | 15 Gew.% | 10 Gew.% |

Die Pasten 5 und 6 wurden für die Herstellung von Sintervorformen (Sintervorformen 5 und 6) verwendet, die wiederum zur Befestigung eines Chips mit einem Substrat eingesetzt wurden. Hierbei wurde analog zu Beispiel 1 vorgegangen, wobei jedoch ein Chip mit einer Fläche von 100 mm² verwendet wurde.

### Ergebnis von Beispiel 2:

Die Scherfestigkeiten der in Beispiel 2 erhaltenen Kontaktschichten zwischen DCB-Substrat und Chip wurden mittels eines herkömmlichen Schertests bestimmt.

Es stellte sich heraus, dass die unter Verwendung von Sintervorform 6 hergestellte Kontaktschicht eine deutlich höhere Scherfestigkeit aufwies als die Kontaktschicht, die unter Verwendung von Sintervorform 5 erhalten wurde. Demnach wirkt sich auch hier der Zusatz des erfindungsgemäßen Sinterhilfsmittels positiv auf die Stabilität der erzeugten Kontaktschicht zwischen Chip und Substrat aus.

## Patentansprüche

1. Sintervorform umfassend einen Träger mit einer Oberfläche, die wenigstens ein Strukturelement aufweist, das verfestigte Paste enthält, **dadurch gekennzeichnet, dass** die verfestigte Paste
(a) Metallpartikel, die ein Coating aufweisen, das wenigstens eine organische Verbindung ausgewählt aus der Gruppe bestehend aus Fettsäuren, Fettsäuresalzen und Fettsäureestern enthält, und
(b) wenigstens ein Sinterhilfsmittel, das aus der Gruppe ausgewählt ist, die aus (b1) Oxidationsmittel darstellenden anorganischen Säuren, (b2) Salzen ausgewählt aus der Gruppe bestehend aus Magnesiumformiat, Aluminiumformiat, Eisen(II)-formiat, Zinn(II)-formiat, Kupfer(II)-formiat, Silber(II)-formiat und Mangan(III)-formiat, (b3) Estern ausgewählt aus der Gruppe bestehend aus Methylformiat, Ethylformiat, Propylformiat und Butylformiat, und (b4) Carbonylkomplexen besteht, enthält,
wobei die verfestigte Paste 75 - 95 Gewichtsprozent Metallpartikel, 0,1 - 15 Gewichtsprozent Sinterhilfsmittel, 0 - 0,5 Gewichtsprozent Lösungsmittel, 0 - 12 Gewichtsprozent Metallprecursor und 0 - 10 Gewichtsprozent weitere Bestandteile enthält, bezogen auf das Gewicht der verfestigten Paste, und die Oberfläche des Trägers, die die verfestigte Paste aufweist, gegenüber den Bestandteilen der Paste nicht reaktiv ist.

2. Sintervorform nach Anspruch 1, **dadurch gekennzeichnet, dass** die Metallpartikel Silberpartikel sind.

3. Sintervorform nach einem der Ansprüche 1 oder 2, **dadurch gekennzeichnet, dass** das molare Verhältnis von Sinterhilfsmitteln zu den im Coating enthaltenen organischen Verbindungen im Bereich von 1 : 1 bis 150 : 1 liegt.

4. Sintervorform nach einem der Ansprüche 1 - 3, **dadurch gekennzeichnet, dass** die anorganische Säure eine Phosphorsäure ist.

5. Sintervorform nach einem der Ansprüche 1 - 4, **dadurch gekennzeichnet, dass** die Carbonylkomplexe aus der Gruppe ausgewählt sind, die aus Metallcarbonylen besteht.

6. Sintervorform nach einem der Ansprüche 1 - 5, **dadurch gekennzeichnet, dass** auf dem wenigstens einen Strukturelement, das die verfestigte Paste enthält, eine Folie aufgebracht ist.

7. Verfahren zum Verbinden wenigstens zweier Bauelemente, bei dem man
(i) eine Sintervorform nach einem der Ansprüche 1 - 6 bereitstellt,
(ii) wenigstens ein erstes Bauelement mit einer zu verbindenden Oberfläche und ein zweites Bauelement mit einer zu verbindenden Oberfläche bereitstellt,
(iii) wenigstens ein Strukturelement auf der Oberfläche des Trägers der Sintervorform mit der zu verbindenden Oberfläche des ersten Bauelements kontaktiert, um eine Anordnung aus dem ersten Bauelement und dem wenigstens einen Strukturelement zu schaffen, die mit dem Träger in Kontakt steht,
(iv) die Anordnung aus dem ersten Bauelement und dem wenigstens einen Strukturelement von dem Träger entfernt,
(v) die zu verbindende Oberfläche des zweiten Bauelements mit dem wenigstens einen Strukturelement der Anordnung aus dem ersten Bauelement und dem wenigstens einen Strukturelement kontaktiert, um eine Sinteranordnung aus erstem Bauelement, zweiten Bauelement und dazwischen angeordnetem Strukturelement zu schaffen, und
(vi) die Sinteranordnung sintert.

8. Verfahren nach Anspruch 7, **dadurch gekennzeichnet, dass** man in Schritt (v) die zu verbindende Oberfläche des zweiten Bauelements mit dem wenigstens einen Strukturelement der Anordnung aus dem ersten Bauelement und dem wenigstens einen Strukturelement über ein weiteres Strukturelement kontaktiert, das Teil einer Anordnung aus dem zweiten Bauelement und diesem Strukturelement ist.

## Claims

1. Sintering preform comprising a support having a surface that comprises at least one structural element containing solidified paste, **characterised in that** the solidified paste contains
(a) metal particles comprising a coating that contains at least one organic compound selected from the group consisting of fatty acids, fatty acid salts, and fatty acid esters; and
(b) at least one sintering aid selected from the group consisting of (b1) inorganic acids representing oxidation agents, (b2) salts selected from the group consisting of magnesium formate, aluminium formate, iron(II) formate, tin(II) formate, copper(II) formate, silver(II) formate, and manganese(III) formate, (b3) esters selected from the group consisting of methyl formate, ethyl formate, propyl formate, and butyl formate, and (b4) carbonyl complexes, whereby the solidified paste contains 75 - 95% by weight metal particles, 0.1 - 15% by weight sintering aid, 0 - 0.5% by weight solvent, 0 - 12% by weight metal precursor, and 0 - 10% by weight further ingredients, based on the weight of the solidified paste, and
the surface of the support comprising the solidified paste is non-reactive with respect to the ingredients of the paste.

2. Sintering preform according to claim 1, **characterised in that** the metal particles are silver particles.

3. Sintering preform according to any one of the claims 1 or 2, **characterised in that** the molar ratio of the sintering aid and the organic compounds contained in the coating is in the range of 1:1 to 150:1.

4. Sintering preform according to any one of the claims 1 - 3, **characterised in that** the inorganic acid is a phosphoric acid.

5. Sintering preform according to any one of the claims 1 - 4, **characterised in that** the carbonyl complexes are selected from the group consisting of metal carbonyls.

6. Sintering preform according to any one of the claims 1 - 5, **characterised in that** a film is applied to the at least one structural element containing the solidified paste.

7. Method for connecting at least two components, in which
(i) a sintering preform according to any one of the claims 1 - 6 is provided;
(ii) at least one first component with a surface to be connected and a second component with a surface to be connected are provided;
(iii) at least one structural element on the surface of the support of the sintering preform is contacted to the surface to be connected of the first component in order to generate an arrangement consisting of the first component and the at least one structural element that is in contact with the support;
(iv) the arrangement consisting of the first component and the at least one structural element is removed from the support;
(v) the surface to be connected of the first component is contacted to the at least one structural element of the arrangement consisting of the first component and the at least one structural element in order to generate a sintering arrangement consisting of first component, second component, and structural element being arranged in between these; and
(vi) the sintering arrangement is sintered.

8. Method according to claim 7, **characterised in that**, in step (v), the surface to be connected of the second component is contacted to the at least one structural element of the arrangement consisting of the first component and the at least one structural element by means of a further structural element that is part of an arrangement consisting of the second component and said structural element.

## Revendications

1. Préforme de frittage comprenant un support avec une surface qui présente au moins un élément structurel qui contient de la pâte solidifiée, **caractérisée en ce que** la pâte solidifiée
(a) contient des particules métalliques qui présentent un revêtement qui contient au moins une liaison organique sélectionnée parmi le groupe composé des acides gras, des sels d'acides gras et des esters d'acides gras, et
(b) au moins un auxiliaire de frittage qui est sélectionné parmi le groupe composé des acides anorganiques représentant des agents d'oxydation (b1), des sels (b2) sélectionnés par le groupe composé du formiate de magnésium, du formiate d'aluminium, du formate (II) de fer, du formiate (II) d'étain, du formiate (II) de cuivre, du formiate (II) d'argent et du formiate (III) de manganèse, des esters (b3) sélectionnés parmi le groupe composé du formiate de méthyle, formiate d'éthyle, formiate de propyle et formiate de butyle et des complexes carbonyliques (b4), dans lequel la pâte solidifiée contient 75 - 95 pourcents en poids de particules métalliques, 0,1 - 15 pourcents en poids d'auxiliaire de frittage 0 - 0,5 de pourcents en poids de solvant, 0 - 12 pourcents en poids de précurseur métallique et 0 - 10 pourcents en poids d'autres composantes, rapporté au poids de la pâte solidifiée et la surface du support qui présente la pâte solidifiée n'est pas réactive par rapport aux composantes de la pâte.

2. Préforme de frittage selon la revendication 1, **caractérisée en ce que** les particules métalliques sont des particules d'argent.

3. Préforme de frittage selon la revendication 1 ou 2, **caractérisée en ce que** le rapport molaire des auxiliaires de frittage aux liaisons organiques contenues dans le revêtement est situé dans la plage de 1:1 à 150:1.

4. Préforme de frittage selon l'une des revendications 1 - 3, **caractérisée en ce que** l'acide anorganique est un acide phosphorique.

5. Préforme de frittage selon l'une des revendications 1 - 4, **caractérisée en ce que** les complexes carbonyliques sont sélectionnés parmi le groupe composé des carbonyles de métal.

6. Préforme de frittage selon l'une des revendications 1 - 5, **caractérisée en ce qu'**un film est appliqué sur l'au moins un élément structuré qui contient la pâte solidifiée.

7. Procédé pour relier au moins deux éléments de construction dans lequel on
(i) fournit une préforme de frittage selon l'une des revendications 1 - 6,
(ii) fournit au moins un premier élément de construction avec une surface à relier et un second élément de construction avec une surface à relier,
(iii) on met en contact au moins un élément structurel sur la surface du support de la préforme avec la surface à relier du premier élément de construction pour créer un agencement du premier élément de construction et de l'au moins un élément structurel, qui est en contact avec le support,
(iv) éloigne du support l'agencement du premier élément de construction et de l'au moins un élément structurel,
(v) met en contact la surface à relier du second élément de construction avec l'au moins un élément structurel de l'agencement du premier élément de construction et de l'au moins un élément structurel pour créer un agencement de frittage du premier élément de construction, du second élément de construction et de l'élément structurel disposé entre, et
(iv) on fritte l'agencement de frittage.

8. Procédé selon la revendication 7, **caractérisé en ce qu'**à l'étape (v), on met en contact la surface à relier du second élément de construction avec l'au moins un élément structurel de l'agencement du premier élément de construction et de l'au moins un élément structurel par le biais d'un autre élément structurel, qui fait partie d'un agencement du second élément structurel et de cet élément structurel.
